Europäisches Patentamt

European Patent Office

Office européen des brevets

(11) Publication number: **0 291 218 B1**

# EUROPEAN PATENT SPECIFICATION

(45) Date of publication of patent specification: **15.09.93**  (51) Int. Cl.5: **C08J 3/11**, C08L 79/04,
//C08J5/24

(21) Application number: **88303991.9**

(22) Date of filing: **03.05.88**

---

(54) **Stable solutions of prepolymers of thiodi(phenylcyanate).**

---

(30) Priority: **04.05.87 US 45082**

(43) Date of publication of application:
**17.11.88 Bulletin 88/46**

(45) Publication of the grant of the patent:
**15.09.93 Bulletin 93/37**

(84) Designated Contracting States:
**BE CH DE FR GB IT LI NL SE**

(56) References cited:
**GB-A- 1 305 762**
**US-A- 4 223 073**

(73) Proprietor: **CIBA-GEIGY AG**
**Klybeckstrasse 141**
**CH-4002 Basel(CH)**

(72) Inventor: **Shimp, David A.**
**10100 Highway 329**
**Prospect Kentucky 40059(US)**

---

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The field of art to which this invention pertains is aryl cyanate esters i.e., cyanic acid esters of polyhydric phenols.

Industry is constantly searching for lighter, stronger and more resistant materials to be used in place of the materials used today. Structural and electrical grade composites made from thermoset or thermoplastic resins and glass or carbon fibers have been and are being used successfully in many applications. However, improved flame retardant and thermally stable compositions are being sought for printed circuit board applications and for structural composites used in aircraft cabins, such as honeycomb panels, floor beams, seats and the like. Composites made with brominated epoxy resins are flame retardant but lack thermal stability. One deficiency of halogenated flame retardant systems is delamination or conductor disbondment in printed circuit boards subjected to field-soldering operations where solder gum contact can elevate board temperature to 350°C. A second deficiency in the use of halogenated resin systems is the generation of toxic, halogenated degradation by-products during fire exposure.

The use of laminates made with polyimides, e.g., adducts of bismaleimides and methylene dianiline, overcomes the above-stated disadvantages of using halogenated epoxy resins. However, polyimides have problems associated with high moisture absorption, brittleness, toxicity of unreacted aromatic diamines and poor storage stability of the resin solutions.

Cyanate esters of polyhydric phenols are finding increasing uses in many structural and electrical applications. Composites based on cured cyanate esters have many excellent properties, such as low moisture absorption, good heat stability and high tensile and flexural strengths.

Cyanate esters made from the reaction of a cyanogen halide and a variety of polyhydric phenols are disclosed in U.S. Patents No. 3,562,214 and No. 4,060,541. Prepolymers of dicyanate esters of dihydric phenols are disclosed in British Patent No. 1,305,762. In U.S. Patents No. 4,223,073 and 4,254,012, prepregs, composites and laminates based on cyanate esters of polyhydric phenols are described.

In U.S. Patent No. 4,430,485, flame retardant polycarbonate and copolyestercarbonate compositions are described. Such compositions are made by incorporating sulfur-containing diphenols in the polycarbonate structures.

This invention is directed to solutions of prepolymers of cyanate esters of dihydric phenols. In one aspect, this invention relates to stable solutions of prepolymers of cyanate esters of 4,4′-thiodiphenol. In another aspect, this invention pertains to stable solutions of prepolymers of cyanate esters of 4,4'-thiodiphenol which can be used to make flame retardant composites, laminates, adhesives and coatings.

The compositions of this invention are stable solutions of prepolymers of thiodi(phenylcyanate) in a solvent selected from the group consisting of dimethylformamide, N-methylpyrrolidone, cyclopentanone and mixtures thereof and optionally other solvents provided that these other solvents are present in an amount of less than 50 weight percent of the total solvent mixture, wherein the prepolymers have 20 to 65 percent of the cyanate groups cyclotrimerized. Flame retardant structural composites, electrical grade laminates and bonding plies for multilayer printed circuit boards are made from these prepolymer solutions by forming prepregs of the prepolymers and fibers and fabrics made from glass, carbon, quartz, polyarylates and aromatic polyamides/polyimides. Adhesive coatings for metal foil conductors are applied by doctor blade or roll coating the prepolymer solutions followed by solvent removal in drying ovens or towers.

Details of Preferred Embodiments

The dicyanate esters used in this invention are made by reacting 4,4'-thiodiphenol with a cyanogen halide in the presence of an acid acceptor, i.e., a base. This reaction is well known and is described in U.S. Patent No. 3,755,402.

The acid acceptors which can be used to prepare the 4,4'-thiodi(phenylcyanate) are inorganic or organic bases, such as sodium hydroxide, potassium hydroxide, sodium methylate, potassium methylate and various amines, preferably tertiary amines. Examples of useful amines are triethylamine, trimethylamine, tripropylamine, diethylpropylamine and pyridine. A preferred base is triethylamine.

The reaction of the cyanogen halide and the dihydric phenol is carried out in an organic solvent, such as ethyl acetate, toluene, xylene, chlorinated hydrocarbons, acetone and diethyl ketone. A preferred solvent is methylene chloride. The reaction is conducted at low temperatures, preferably between -30°C and 15°C.

4,4′-Thiodi(phenylcyanate) is prepolymerized by cyclotrimerizing part of the cyanate ester groups. The prepolymers are made by heating the dicyanate ester with or without catalysts at a temperature of 100°C to 240°C for a time sufficient to cyclotrimerize 20 to 65 percent of the cyanate functional groups and, preferably, 30 to 60 percent. Catalysts which can be used in preparing the prepolymers are mineral or

2

Lewis acids, bases such as alkali metal hydroxides, alkali metal alcoholates or tertiary amines, salts such as sodium carbonate or lithium chloride, or active hydrogen containing compounds, such as bisphenols and monophenols. It is preferred to conduct the prepolymerization reaction without a catalyst utilizing only heat followed by thermal quenching in the manner taught in British Patent No. 1,305,762.

Cyanate ester content can be determined quantitatively by infrared analysis or by "residual heat of reaction" using a differential scanning calorimeter. The percent trimerization is calculated by the formula:

$$Percent\ Trimerization = 100 - \left[\frac{Wt/OCN\ Monomer}{Wt/\ OCN\ Prepolymer} \times 100\right]$$

wherein Wt/OCN is the equivalent weight per cyanate group.

Refractive index is directly related to the percent trimerization. A plot of refractive indices, taken at the same temperature, versus percent trimerization is linear. The slope of the plotted line will vary with the chemical composition of the particular cyanate ester being prepolymerized and the prism temperature. By using the plot, the refractive index can be used to monitor the rate of reaction and the extent of the cyclotrimerization reaction.

The prepolymer solutions of this invention are made by dissolving the prepolymer in the solvent at a solids content of 25 to 90 weight percent. The solids content is adjusted to give a solution viscosity of 30 to 5,000 cps (mPa.s). The preferred solids content is 40 to 80 weight percent.

The solvents used to form the solutions of this invention are dimethylformamide, N-methylpyrrolidone and cyclopentanone. Mixtures of these solvents can also be used. In order to obtain solutions of prepolymers of 4,4'-thiodi(phenylcyanate) which are stable for all seasons storage and shipping, the above listed solvents must be used. Minor amounts of other solvents can be used in admixture with the listed solvents. If the solvents used to form the solution are not more than 50 weight percent of dimethylformamide, N-methylpyrrolidone or cyclopentanone, the solutions will increase in viscosity, will solidify, or will precipitate from solution forming hazy or white dispersions. The fact that stable solutions of 4,4'-thiodi-(phenylcyanate) prepolymers can only be prepared with these solvents is surprising since stable solutions of prepolymers of other cyanate esters, e.g. dicyanate esters made from Bisphenol A and bis(4-hydroxy-3,5-dimethylphenyl) methane, can be made from commonly used prepreg solvents, e.g., methyl ethyl ketone and acetone.

Prepregs are formed from the prepolymer solutions of this invention and fibers and fabrics made from glass, carbon, quartz, polyarylates, aromatic polyamides/polyimides, paper, metal filaments and the like. Such prepregs are made by contacting the fiber or fabric with the prepolymer solution and then evaporating the solvent to solidify the resin on the fiber or fabric. This process can be conducted manually by dipping, striking off excess solution and drying in a forced air oven, or in a continuous manner by immersing the tensioned fabric or tow in the prepolymer solutions using conventional treaters with squeeze rollers and vertical drying towers.

Drying is conducted at a temperature range of 220°F (104.4°C) to 375°F (190.6°C) for a time, generally 1 minute to 20 minutes, sufficient to lower the solvent content in the prepreg to below 5 weight percent basis.

After drying, stiff (boardy) prepregs can be stored at room temperature; tacky, drapable prepregs can be stored at 32°F (0°C) or below for periods of up to 12 months without advancing too far in cure.

Prior to forming the prepregs, curing catalysts are added to the prepolymer solutions. Such curing catalysts include those described hereinbefore which can be used to prepare prepolymers. Additional catalysts are those described in U.S. Patent Nos. 3,962,184, 3,694,410 and 4,026,213 and 4,608,434. Examples of such catalysts include zinc octoate, manganese octoate, zinc stearate, tin stearate, copper acetylacetonate, phenol, catechol, triethylenediamine and chelates of iron, cobalt, zinc, copper, manganese and titanium with bidentate ligands, such as catechol. Such catalysts are used in the amounts of 0.001 to 20 parts by weight per 100 Parts by weight of prepolymer. A preferred catalyst system is that described in U.S. Patent No. 4,604,452. Such catalysts are liquid solutions of a metal carboxylate and an alkylphenol, e.g., copper naphthenate and nonylphenol. These catalysts are used in the amounts of 0.001 to 0.5 part by weight of metal and 1 to 20 parts by weight of alkylphenol per 100 parts by weight of prepolymer.

The prepreg fabrics and tapes are formed into cured laminates using conventional procedures such as press molding under platen pressure or bag molding under vacuum in a gas-pressured autoclave.

The prepolymer solutions of this invention can also be used by filament winding prepreg fiber tows or tapes, and by bonding coated conductor foil or adhesive interplies in laminate fabrication processes.

The cyanate ester prepregs are cured in the molding operations by being heated at elevated temperatures for a time to achieve a useful degree of conversion (or cure), i.e., until at least 80 percent of the cyanate functional groups originally present in the cyanate ester are cyclotrimerized. The curing reaction can be conducted at one temperature or can be conducted by heating in steps. If conducted at one temperature, the temperature will vary from 250°F (121.1°C) to 450°F (232.2°C). When conducted by stepwise heating, the first step, or gelation step, is performed at a temperature of 150°F (65.6°C) to 350°F (176.7°C). The curing step is conducted at a temperature of 300°F (148.9°C) to 400°F (204.4°C) and the optional post-curing step is conducted at a temperature of 400°F (204°C) to 550°F (287.8°C). The overall curing reaction takes 5 minutes to 8 hours.

Laminates prepared from the thiodi(phenylcyanates) exhibit low moisture absorption, low dielectric constant, high copper peel strength, flame retardancy, thermal stability and toughness.

The following examples describe the invention in greater detail, except Examples 6 and 7, which are for comparison purposes. Parts and percentages unless otherwise designated are parts and percentages by weight. Viscosities expressed in Gardner-Holdt values can be converted into their approximate SI equivalents as follows: A, 0.05 Pas; B, 0.065 Pas; D, 0.1 Pas; E, 0.125 Pas; F, 0.14 Pas; G, 0.165 Pas; G-H, 0.18 Pas; H, 0.2 Pas; I, 0.225 Pas; J, 0.25 Pas; K, 0.275 Pas; L, 0.3 Pas; O,0.37; P, 0.4 Pas; Q, 0.435 Pas; R,0.47 Pas; S, 0.5 Pas; V, 0.884 Pas; Y,1.76 Pas; Z, 2.27 Pas; $Z_2$, 3.4 Pas; $Z_7$, 20 Pas. In Tables I and II (Examples 6 and 7) hereinafter, the symbol 'OK' means 'satisfactory'.

Example 1

To a suitable reactor were added 1050 parts of methylene chloride. Cyanogen chloride gas, 202.8 parts, was added by means of a sparge over a period of 1 hour and 23 minutes while keeping the temperature between 1.5 and 7.2°C. The temperature was lowered to 40°C and a solution of 359.9 parts of 4,4'-thiodiphenol in 360 parts of acetone was added over 18 minutes with the temperature rising to 8°C. The temperature was then lowered to -10°C and 329.8 parts of triethylamine were added over a period of 56 minutes with the temperature being controlled between -10°C and -8°C. During the addition, 600 parts of acetone were added to reduce the viscosity of the reacting mixture. The product in methylene chloride solution was washed with 1800 parts of water. The washing was repeated 3 more times. When the washing was completed, vacuum and heat were applied to remove the methylene chloride to a concentration of 70 percent non-volatiles. The solution was chilled to 40°F (4.4°C), and the precipitated crystals were removed by filtration. After drying under vacuum, the yield of 4,4'-thiodi(phenylcyanate) was 352.2 parts. The purity, determined by Differential Scanning Calorimeter was 98.9 percent. The melting point was 93.7°C.

Example 2

To a suitable reactor were added 600 parts of 4,4'-thiodi(phenylcyanate). Heat, agitation and a nitrogen sparge were applied. The temperature was raised to 116°C at which point, the crystalline cyanate ester was fully melted. The rate and extent of the cyclotrimerization reaction were determined by measuring the refractive index (R.I) at 100°C. The initial refractive index, the fully melted material, was 1.5852. The temperature was raised to 165°C and the reaction was continued for 5 hours. The refractive index was 1.6156 at the end of this period, which indicated 29.3 percent trimerization. After an additional 30 minutes heating at 165°C, the R.I. was 1.6186 indicating 31.6 trimerization. Heating was discontinued, allowing the temperature to reach room temperature and remain at room temperature overnight. Heating was resumed to raise the temperature to 165°C. At this point, the RI was 1.6262 which indicated 37.8 percent trimerization. After 90 minutes additional heating at 165°C, the R.I was 1.6340 and the percent trimerization was 44.2 percent. Fifty minutes later, the temperature had been decreased to 160°C. The R.I. was 1.6383 and the percent trimerization was 48.6 percent. After 20 minutes additional heating at 160°C, the R.I. was 1.6405, the percent trimerization was 51.4 percent, and the physical appearance of a prepolymer sample cooled to room temperature was an amorphous, amber colored hard resin.

Example 3

A solution was made from 55 parts of the prepolymer of 4,4'-thiodi(phenylcyanate) and 45 parts of dimethylformamide. Two viscosity tubes were filled with the solution. One tube was kept at 77°F (25°C), the other at 40°F (4.4°C). The Gardner-Holdt viscosity at 25°C was determined periodically and the solutions were checked for signs of thickening, separation or other instability. The initial viscosity was D and the solution was clear. After 31 days at 77°F (25°C) and 11 days at 40°F (4.4°C), the solution remained clear and the viscosities remained at D.

## Example 4

Another solution was prepared from the 4,4'-thiodi(phenylcyanate) prepolymer and cyclopentanone at 55 percent solids and the stability was determined using the procedure described in Example 3. The solution was clear and the viscosity was G. After 6 days at 77°F (25°C), the viscosity was G-H and the solution was clear. After 3 weeks at 77°F (25°C), the solution was still clear and the viscosity was still G-H. The viscosity of the solution kept at 40°F (4.4°C), was G-H after 9 days and remained at G-H after 3 weeks.

## Example 5

Another solution was prepared from the 4,4'-thiodi(phenylcyanate) prepolymer and N-methylpyrrolidone and the stability was determined using the procedure described in Example 3. The initial viscosity was J and the solution was clear. The viscosity of the solution kept at 77°F (25°C) was J-K after 3 days, L after 11 days, M after 25 days and N after 31 days. The viscosity of the solution kept at 40°F (4.4°C) remained at J after 11 days. The solutions in both instances remained clear.

## Example 6

Additional solutions were made with the 4,4'-thiodi(phenylcyanate) prepolymer and other solvents or mixtures of solvents at 55 percent solids. The stability of the solutions was determined using the procedure described in Example 3. The solvents and viscosity data are listed in Table I.

**TABLE I**

| Solvent | Days at 77°F (25°C) | | | | | | Days at 40°F (4.4°C) | | |
| --- | --- | --- | --- | --- | --- | --- | --- | --- | --- |
| | Initial | 1 | 3 | 11 | 25 | 31 | 1 | 3 | 11 |
| Dimethyl-formamide 50% | Clear | Clear | Clear | Clear | Clear | Clear | Clear | Clear | Clear |
| Cyclo-hexanone 50% | H | H | H-I | I-J | I-J | I-J | OK | OK | >Z$_7$ |
| Dimethyl-formamide 50% | Clear | Clear | Clear | Cloudy | | | Hazy | | |
| Nitro-methane 50% | B | B | D | >Z$_7$ | | | >Z$_7$ | | |
| Dimethyl-formamide 50% | Clear | Clear | Hazy | | | | White | | |
| Acetonitrile 50% | A | A | >Z$_7$ | | | | >Z$_7$ | | |
| Dimethyl-formamide 50% | Clear | Clear | Clear | Cloudy | | | Hazy | | |
| Acetone 50% | B | B | B | >Z$_7$ | | | >Z$_7$ | | |
| N-Methyl-pyrrolidone 50% | Clear | Clear | Clear | Clear | | Hazy | Clear | Clear | White |
| Acetone 50% | A | A | A | A | | >Z$_7$ | OK | OK | >Z$_7$ |
| N-Methyl-pyrrolidone 50% | Clear | Clear | Clear | Clear | Clear | Clear | Clear | Clear | Clear |
| Cyclo-hexanone 50% | O | O | O-P | P | Q | R | OK | OK | >Z$_7$ |
| Cyclo-hexanone 50% | Clear | Clear | Clear | Hazy | | | Clear | Hazy | |
| Nitro-methane 50% | E | E | F | >Z$_7$ | | | OK | >Z$_7$ | |
| Cyclo-hexanone 50% | Clear | Clear | Clear | Cloudy | | | Clear | White | |
| Acetonitrile 50% | A | A | A | >Z$_7$ | | | OK | >Z$_7$ | |

Example 7

More solutions were made with the prepolymer of 4,4′-thiodi(phenylcyanate) and solvents or solvent mixtures at 65 percent solids. The solvents and viscosity data are listed in Table II.

6

Table II

| Solvent | Initial | Days at 40°F (4.4°C) | | Days at 77°F (25°C) | | |
|---|---|---|---|---|---|---|
| | | 1 | 7 | 3 | 7 | 21 |
| Cyclohexanone | Clear Z₂ | Cloudy Stiff | | Clear Solid | | |
| Cyclohexanone 50% N-Methyl-pyrrolidone 50% | Clear Y-Z | Clear | Hazy Stiff | Clear OK | Clear OK | Clear OK |
| Cyclohexanone 50% Nitromethane 50% | Clear L | Cloudy Stiff | | Clear OK | Hazy Solid | |
| Cyclohexanone 50% t-Butanol 50% | White >Z₇ | White Stiff | | White Stiff | | |
| Cyclohexanone 50% Acetonitrile 50% | Clear K | Cloudy Stiff | | Clear OK | Cloudy Stiff | |
| Cyclohexanone 50% Isopropanol 50% | White >Z₇ | White Stiff | | White Stiff | | |
| Acetonitrile | White K | White Stiff | | White Stiff | | |
| Acetonitrile 50% N-Methyl-pyrrolidone 50% | Clear J | Cloudy Stiff | | Clear OK | Hazy Solid | |
| Acetonitrile 50% t-Butanol 50% | White >Z₇ | White Stiff | | White Stiff | | |
| Acetonitrile 50% Diacetone Alcohol 50% | Clear O | White Stiff | | White Stiff | | |
| Acetone 50% N-Methyl-pyrrolidone 50% | Clear S | Hazy Flows | White Stiff | Clear OK | Hazy Liquid | |

| Nitromethane 50%<br>Acetonitrile 50% | Clear<br>G | White<br>Stiff | | Hazy<br>Stiff | |
| Nitromethane 50%<br>Isopropanol 50% | White | White<br>Stiff | | White<br>Stiff | |
| Nitromethane 50%<br>N-Methyl-<br>pyrrolidone 50% | Clear<br>V | Hazy<br>Stiff | Cloudy<br>Stiff | Clear<br>OK | Hazy<br>Stiff |

Example 8

To 1500 parts of a prepolymer solution in dimethylformamide of 825 parts of a prepolymer of 4,4'-thiodi(phenylcyanate) having an R.I at 110°C of 1.6450 were added 0.233 part of a solution at 40 percent solids of manganese octoate in mineral spirits. The gel time of the prepolymer varnish was found to be 167 seconds at 340°F (171.1°C). Prepregs were made by saturating glass cloth with the catalyzed prepolymer solution and the resin was "B" staged by heating at 290°F (143.3°C) for 4 minutes. The resin content of the fiber glass prepreg was 50 percent and the volatile content ranged from 1.0 to 1.5 percent.

Eight ply laminates were made from the prepregs using a press at 89 psig (614 kPa). The press was heated from 77°F (25°C) to 230°F (110°C) at a rate of 15°F (8.3 Celsius degrees) per minute and was held at 230°F (110°C) for 20 minutes. The temperature was then raised to 350°F (176.7°C) at 15°F (8.3 Celsius degrees) per minute and was held for 60 minutes at 350°F (176.7°C). The laminates were then post cured for 1 hour at 420°F (215.6°C), 2 hours at 450°F (232.2°C) and 4 hours at 480°F (248.9°C). The Tg after each post curing period was 233°C, 234°C and 240°C.

Typical properties of the laminates are listed in Table III.

## Table III

### Properties of Cured 4,4'-Thiodi(phenylcyanate) Laminate

**Properties**

| | |
|---|---|
| Flammability (UL-94 Test) | VO-VI |
| Dielectric Constant, R.T | 4.56 |
| D-48/50 | 4.83 |
| Dissipation Factor, R.T | .0046 |
| D-48/50 | .0097 |
| Peel Strength, R.T (a) | 11.0 lbs/inch (1926 N/m) |
| 100°C | 10.7 lbs/inch (1873 N/m) |
| 200°C | 10.2 lbs/inch (1786 N/m) |
| Thermal Stability | |
| 100 hours @ 200°C | |
| Percent weight loss | 0.19 |

(a) Clad with 2 oz. (56.7g) treated copper foil.

## Claims

1. A stable solution of a prepolymer of 4,4'-thiodi(phenylcyanate) comprising:
   A) a prepolymer of 4,4'-thiodi(phenylcyanate) wherein 20 to 65 percent of the cyanate groups are cyclotrimerized; and
   B) a solvent selected from dimethylformamide, N-methylpyrrolidone, cyclopentanone and mixtures thereof and optionally other solvents provided that these other solvents are present in an amount of less than 50 weight percent of the total solvent mixture.

2. The solution of claim 1 wherein the prepolymer forms 40 to 80 weight percent of the total weight of the solution.

3. The solution of claim 1 or 2 wherein the viscosity at 25°C is 30 to 5,000 centipoise (mPa.s).

4. The solution of any of claims 1-3 wherein 30 to 60 percent of the cyanate groups are cyclotrimerized.

5. A process for preparing a flame retardant laminate by the steps of:
   a) impregnating fibers with a solution of a prepolymer of a polycyanate ester;
   b) heating the impregnated fibers to remove solvent and to "B" stage the prepolymer, and
   c) heating under pressure one or more plies of the "B" staged impregnated fibers to cure the prepolymer, characterised in that the solution of the prepolymer is a solution of a prepolymer of 4,4'-thiodi(phenylcyanate) in a solvent selected from dimethylformamide, N-methylpyrrolidone, cyclopentanone and mixtures thereof wherein the cyanate groups in the prepolymer are 20 to 65 percent trimerized.

6. The process of claim 5 wherein the prepolymer solution contains 40 to 80 weight percent of the prepolymer, based on the total weight of the solution.

7. The process of claim 5 or 6 wherein the viscosity of the prepolymer solution is 30 to 5,000 centipoise (mPa.s).

8. The process of any of claims 5-7 wherein 30 to 60 percent of the cyanate groups are cyclotrimerized.

**Patentansprüche**

1. Stabile Lösung eines Präpolymers von 4,4'-Thiodi(phenylcyanat) umfassend:
   A) ein Präpolymer von 4,4'-Thiodi(phenylcyanat), worin 20 bis 65 % der Cyanatgruppen cyclotrimerisiert vorliegen; und
   B) ein Lösungsmittel, ausgewählt aus Dimethylformamid, N-Methylpyrrolidon, Cyclopentanon und Gemischen davon und gegebenenfalls andere Lösungsmittel, mit der Maßgabe, daß diese anderen Lösungsmittel in einer Menge von weniger als 50 Gew.-%, bezogen auf das Gesamtlösungsmittelgemisch, vorliegen.

2. Lösung nach Anspruch 1, wobei das Präpolymer 40 bis 80 Gew.-% des Gesamtgewichts der Lösung ausmacht.

3. Lösung nach Anspruch 1 oder 2, wobei die Viskosität bei 25°C 30 bis 5000 Centipoise (mPa•s) beträgt.

4. Lösung nach einem der Ansprüche 1-3, wobei 30 bis 60 % der Cyanatgruppen cyclotrimerisiert vorliegen.

5. Verfahren zur Herstellung eines flammenhemmenden Laminats durch die Schritte:
   a) Imprägnieren von Fasern mit einer Lösung eines Präpolymers von einem Polycyanatester;
   b) Erhitzen der imprägnierten Fasern, um das Lösungsmittel zu entfernen und Überführen des Polymers in den B-Zustand und
   c) Erhitzen unter Druck einer oder mehrerer Schichten der im B-Zustand imprägnierten Fasern zum Härten des Präpolymers, **dadurch gekennzeichnet**, daß die Lösung des Präpolymers eine Lösung eines Präpolymers von 4,4'-Thiodi(phenylcyanat) in einem Lösungsmittel, ausgewählt aus Dimethylformamid, N-Methylpyrrolidon, Cyclopentanon und Gemischen davon ist, wobei die Cyanatgruppen in dem Präpolymer zu 20 bis 65 % trimerisiert vorliegen.

6. Verfahren nach Anspruch 5, wobei die Präpolymerlösung 40 bis 80 Gew.-% des Präpolymers, bezogen auf das Gesamtgewicht der Lösung, enthält.

7. Verfahren nach Anspruch 5 oder 6, wobei die Viskosität der Präpolymerlösung 30 bis 5000 Centipoise (mPa•s) beträgt.

8. Verfahren nach einem der Ansprüche 5-7, wobei 30 bis 60 % der Cyanatgruppen cyclotrimerisiert vorliegen.

**Revendications**

1. Solution stable d'un prépolymère de 4,4'-thiodi(cyanate de phényle) comprenant :
   (A) un prépolymère de 4,4'-thiodi(cyanate de phényle) dans lequel 20 à 65 pour cent des groupes cyanate sont cyclotrimérisés ; et
   (B) un solvant choisi parmi le diméthylformamide, la N-méthylpyrrolidone, la cyclopentanone et leurs mélanges, et facultativement d'autres solvants, à condition que ces autres solvants soient présents en une quantité inférieure à 50 pour cent en poids du mélange de solvants total.

**2.** Solution de la revendication 1, dans laquelle le prépolymère constitue 40 à 80 pour cent en poids du poids total de la solution.

**3.** Solution de la revendication 1 ou 2, dans laquelle la viscosité à 25°C est de 30 à 5000 centipoises (mPa.s).

**4.** Solution de l'une quelconque des revendications 1 à 3, dans laquelle 30 à 60 pour cent des groupes cyanate sont cyclotrimérisés.

**5.** Procédé de préparation d'un stratifié retardateur de flamme par les étapes suivantes :
a) imprégnation de fibres avec une solution d'un prépolymère d'un polycyanate ;
b) chauffage des fibres imprégnées pour éliminer le solvant et faire mûrir le polymère au stade "B", et
c) chauffage sous pression d une ou plusieurs couches des fibres imprégnées mûries au stade "B" pour faire durcir le prépolymère,
caractérisé en ce que la solution du prépolymère est une solution d'un prépolymère de 4,4'-thiodi-(cyanate de phényle) dans un solvant choisi parmi le diméthylformamide, la N-méthylpyrrolidone, la cyclopentanone et leurs mélanges, où 20 à 65 pour cent des groupes cyanate du prépolymère sont trimérisés.

**6.** Procédé de la revendication 5, dans lequel la solution de prépolymère contient 40 à 80 pour cent en poids du prépolymère, par rapport au poids total de la solution.

**7.** Procédé de la revendication 5 ou 6, dans lequel la viscosité de la solution de prépolymère est de 30 à 5000 centipoises (mPa.s).

**8.** Procédé de l'une quelconque des revendications 5 à 7, dans lequel 30 à 60 pour cent des groupes cyanate sont cyclotrimérisés.